# EUROPEAN PATENT APPLICATION

(11) **EP 2 693 490 A1**
(43) Date of publication of application: **05.02.2014**
(21) Application number: 12763956.5
(22) Date of filing: 15.03.2012
(51) Int. Cl.: H01L 31/042, B32B 27/20

(54) **PROTECTIVE SHEET FOR SOLAR CELL, METHOD FOR PRODUCING SAME, AND SOLAR CELL MODULE**

(30) Priority: 30.03.2011 JP 2011074779
(71) Applicant: LINTEC Corporation, Tokyo 173-0001 (JP)
(72) Inventor: TAKANASHI, Yasunari, Tokyo 173-0001 (JP); NAITOU, Masato, Tokyo 173-0001 (JP); TAYA, Naoki, Tokyo 173-0001 (JP)
(74) Representative: Raynor, Stuart Andrew
(86) International application number: PCT/JP2012/056669
(87) International publication number: WO 2012/132921

(57) **Abstract**

Solar cell protective sheet 1A comprises a substrate 11 and a thermoplastic resin layer 12A laminated on at least one surface of the substrate 11. The thermoplastic resin layer 12A contains at least one pigment selected from the group consisting of titanium oxide, talc, magnesium oxide, cerium oxide, barium sulfate, calcium carbonate and carbon black. The solar cell protective sheet 1A has excellent adhesiveness to an encapsulant of a solar cell module and can suppress the warping caused in the solar cell module.

## Description

### [Technical Field]

The present invention relates to a solar cell protective sheet used as a front surface protective sheet or a back surface protective sheet of a solar cell module and a producing method of the same, and relates also to a solar cell module using the solar cell protective sheet.

### [Background Art]

A solar cell module, which converts the light energy from the sun to electrical energy, attracts attention as a clean energy source capable of generating electricity without emitting carbon dioxide to cope with environmental issues, such as air pollution and global warming.

In general, a solar cell module may be configured of: solar cells, comprised of crystal silicon, amorphous silicon or the like, to perform photoelectric conversion; an encapsulant (filling layer), comprised of an electrical insulator, to encapsulate the solar cells; a front surface protective sheet (front sheet) laminated on the front surface of the encapsulant (light receiving surface); and a back surface protective sheet (back sheet) laminated on the back surface of the encapsulant. In order for the solar cell module to have weatherability and durability sustainable for long period of time in outdoor and indoor use, it may be required to protect the solar cells and the encapsulant from weather, humidity, fugitive dust, mechanical impact and the like, and avoid the interior of the solar cell module from exposure to the external air thereby to keep hermetically closed state. In this respect, a solar cell protective sheet is required to have weatherability and durability sustainable for long period use.

Patent Literature 1 discloses a solar cell module in which silicon power generating elements are encapsulated in an encapsulant formed of ethylene-vinyl acetate copolymer sheet, and a back sheet is laminated on the back surface of the encapsulant. Disclosed back sheet is such that a fluorine-based plastic film (Tedlar film available from DuPont) having weatherability adheres to either surface or each of both surfaces of a layer that prevents water vapor permeation, such as formed of metal. This back sheet may be applied to the above encapsulant by being heated and pressed thereon.

However, the conventional back sheet as disclosed in Patent Literature 1 has had a problem that the back sheet may possibly delaminate from the encapsulant so that water vapor permeates into the encapsulant because of poor adhesiveness to the encapsulant. In this respect, it is proposed to improve adhesiveness to (peel resistance from) the above encapsulant by forming a thermally adhesive layer on the back sheet.

Patent Literature 2 specifically discloses a back sheet laminated on the back surface of a filling material in a solar cell module that uses ethylene-vinyl acetate copolymer as the filling material, wherein a thermally adhesive layer is laminated on a heat-resistant film, and the thermally adhesive layer comprises a thermally adhesive resin that contains, as the main component, graft-modified ethylene-(meth)acrylic acid ester copolymer, ethylene-vinyl acetate copolymer or mixture thereof by using epoxy compound and/or silane compound.

### [Prior Art Literature]

### [Patent Literature]

[Patent Literature 1] JP6-177412A
[Patent Literature 2] JP2008-108947A

### [Summary of the Invention]

### [Problems to be solved by the Invention]

According to Patent Literature 2, when the back sheet is produced, the thermally adhesive layer may be laminated on the heat-resistant film by using extrusion coating method. Such a forming method for the thermally adhesive layer may have high productivity, but involves a problem that some contraction may occur due to cooling of the thermally adhesive layer so that curl occurs in the width direction of rolls or the flow direction. The curl of the back sheet may cause the solar cell module to warp, and not only troubles may occur at the time of installing the solar cell module, but also the solar cell module may possibly be damaged.

The present invention has been created in view of such circumstances, and objects of the present invention include providing a solar cell protective sheet that has excellent adhesiveness to an encapsulant of a solar cell module and can suppress the warping caused in the solar cell module, providing a producing method of the same, and providing a solar cell module that has excellent adhesiveness between the encapsulant and the solar cell protective sheet and is suppressed from warping.

### [Means for solving the Problems]

In order to achieve the above objects, first, the present invention provides a solar cell protective sheet comprising a substrate and a thermoplastic resin layer laminated on at least one surface of the substrate, wherein the thermoplastic resin layer comprises at least one pigment selected from the group consisting of titanium oxide, talc, magnesium oxide, cerium oxide, barium sulfate, calcium carbonate and carbon black (Invention 1).

The solar cell protective sheet according to the above invention (Invention 1) has excellent adhesiveness to an encapsulant of a solar cell module and can suppress the warping caused in the solar cell module because the curl amount is small.

In the above invention (Invention 1), the thermoplastic resin layer may be a single layer and contain an olefin-based resin as a main component, and the olefin-based resin may have a density of 875 to 920 kg/m³ and a heat of fusion ΔH measured with a differential scanning calorimeter of 100 J/g or less (Invention 2).

In the above invention (Invention 2), it is preferred that the thermoplastic resin layer contains 2.5 to 35 mass% of the pigment (Invention 3).

In the above invention (Invention 1), it is preferred that the thermoplastic resin layer comprises: a first layer laminated on the substrate and exhibiting adhesiveness to the substrate; and a second layer laminated on the first layer and containing an olefin-based resin as a main component, and the olefin-based resin of the second layer has a density of 875 to 920 kg/m³ and a heat of fusion ΔH measured with a differential scanning calorimeter of 100 J/g or less (Invention 4).

In the above invention (Invention 4), it is preferred that the pigment is contained in the second layer (Invention 5).

In the above invention (Invention 5), it is preferred that 2.5 to 35 mass% of the pigment is contained in the second layer (Invention 6).

In the above inventions (Inventions 2-6), it is preferred that the olefin-based resin contains 60 to 100 mass% of ethylene as a monomer unit (Invention 7).

In the above inventions (Inventions 4-6), it is preferred that the first layer mainly contains a copolymer of ethylene and at least one selected from the group consisting of (meth)acrylic acid, (meth)acrylic acid ester and vinyl acetate (Invention 8).

In the above invention (Invention 8), it is preferred that a total content of (meth)acrylic acid, (meth)acrylic acid ester and vinyl acetate as a monomer unit in the copolymer of the first layer is 2 to 40 mass% (Invention 9).

In the above invention (Invention 8, 9), it is preferred that (meth)acrylic acid ester as a monomer unit in the copolymer of the first layer is at least one selected from the group consisting of methyl acrylate, butyl acrylate, 2-ethylhexyl acrylate and methyl methacrylate (Invention 10).

In the above inventions (Inventions 1-10), it is preferred that the thermoplastic resin layer is formed by extrusion coating (Invention 11).

In the above inventions (Inventions 1-11), it is preferred that the thermoplastic resin layer is a layer to be adhered to an encapsulant that constitutes a solar cell module (Invention 12).

Second, the present invention provides a producing method of a solar cell protective sheet comprising a substrate and a thermoplastic resin layer laminated on at least one surface of the substrate comprising: extrusion coating the thermoplastic resin composition, which comprises an olefin-based resin as a main component, the olefin-based resin having a density of 875 to 920 kg/m³ and a heat of fusion ΔH measured with a differential scanning calorimeter of 100 J/g or less, and at least one pigment selected from the group consisting of titanium oxide, talc, magnesium oxide, cerium oxide, barium sulfate, calcium carbonate and carbon black, onto at least one surface of the substrate, then forming the thermoplastic resin layer (Invention 13).

Third, the present invention provides a producing method of a solar cell protective sheet comprising a substrate and a thermoplastic resin layer laminated on at least one surface of the substrate comprising: co-extrusion coating a first resin composition and a second resin composition onto at least one surface of the substrate so that the first resin composition is located at a side of the substrate, the first resin composition has an adhesiveness to the substrate and the second resin composition comprises an olefin-based resin as a main component and at least one pigment selected from the group consisting of titanium oxide, talc, magnesium oxide, cerium oxide, barium sulfate, calcium carbonate and carbon black, the olefin-based resin having a density of 875 to 920 kg/m³ and a heat of fusion ΔH measured with a differential scanning calorimeter of 100 J/g or less, then forming the thermoplastic resin layer which comprises the first layer laminated on the substrate comprising the firs resin composition and the second layer laminated on the first layer comprising the second resin composition (Invention 14).

Fourth, the present invention provides a solar cell module comprising a solar cell, an encapsulant that encapsulates the solar cell, and a solar cell protective sheet laminated on the encapsulant, the protective sheet comprising the solar cell protective sheet (Invention 12), the solar cell protective sheet adhering to the encapsulant via the thermoplastic resin layer (Invention 15).

### [Advantageous Effect of the Invention]

The solar cell protective sheet according to the present invention has excellent adhesiveness to the encapsulant of the solar cell module and can suppress the warping caused in the solar cell module because the curl amount is small. According to the method for producing a solar cell protective sheet of the present invention, such a solar cell protective sheet can be obtained to have excellent advantageous effects as described above. In the solar cell module according to the present invention, adhesiveness between the encapsulant and the solar cell protective sheet is excellent, and warping due to the curl of the solar cell protective sheet is suppressed.

### [Brief Description of Drawings]

[FIG. 1] FIG. 1 is a schematic cross-sectional view of a solar cell protective sheet according to one embodiment of the present invention.
[FIG. 2] FIG. 2 is a schematic cross-sectional view of a solar cell protective sheet according to another embodiment of the present invention.
[FIG. 3] FIG. 3 is a schematic cross-sectional view of a solar cell protective sheet according to another embodiment of the present invention.
[FIG. 4] FIG. 4 is a schematic cross-sectional view of a solar cell protective sheet according to another embodiment of the present invention.
[FIG. 5] FIG. 5 is a schematic cross-sectional view of a solar cell protective sheet according to another embodiment of the present invention.
[FIG. 6] FIG. 6 is a schematic cross-sectional view of a solar cell protective sheet according to a second embodiment of the present invention.
[FIG. 7] FIG. 7 is a schematic cross-sectional view of a solar cell module according to one embodiment of the present invention.
[FIG. 8] FIG. 8 is a schematic cross-sectional view of a solar cell module according to another embodiment of the present invention.

### [Embodiments for Carrying out the Invention]

Embodiments of the present invention will hereinafter be described.

### <<Solar cell protective sheet (1)>>

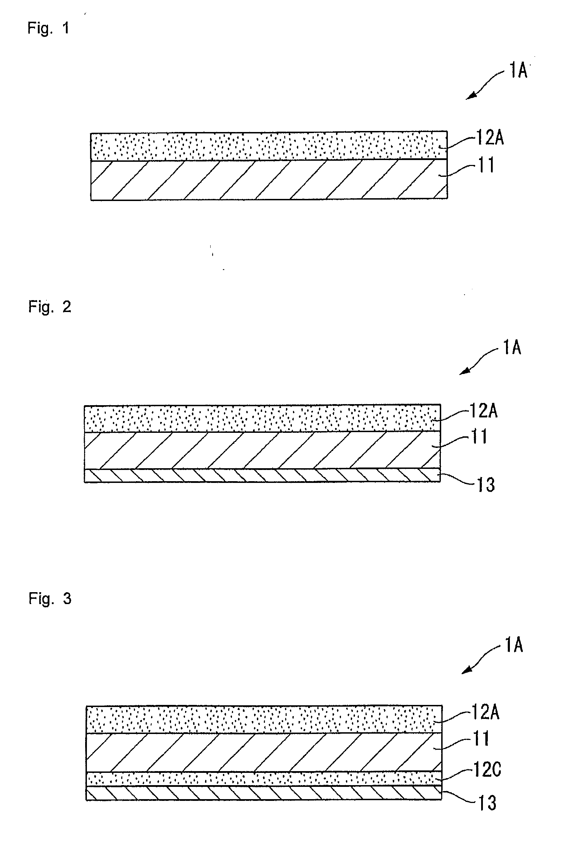

As shown in FIG. 1, protective sheet 1A according to the first embodiment may comprise a substrate 11 and a thermoplastic resin layer 12A laminated on one surface (upper surface in FIG. 1) of the substrate 11. This protective sheet 1A may be used preferably as a back surface protective sheet (back sheet) of a solar cell module.

The substrate 11 may be sufficient in general if it has electrical insulation property and is capable of being laminated thereon with the thermoplastic resin layer 12A, and those mainly comprised of resin films may typically be used.

The resin film used for the substrate 11 may be selected from resin films commonly used in back sheets for solar cell modules. Examples of such resin films used include films or sheets comprising, for example, polyolefin-based resin such as polyethylene and polypropylene, polyester-based resin such as polyethylene terephthalate (PET) and polyethylene naphthalate, polyamide-based resin such as nylon (trade name), polycarbonate-based resin, polystyrene-based resin, polyacrylonitrile-based resin, polyvinyl chloride-based resin, polyvinyl acetal-based resin, polyphenylene sulfide resin, polyphenylene ether resin, fluorine-based resin, and/or other appropriate resin. Among these resin films, a film comprising polyester-based resin is preferable, and a PET film is particularly preferable.

The above resin film may contain, as necessary, various additives, such as pigment, ultraviolet absorber, ultraviolet stabilizer, flame retardant, plasticizer, antistatic agent, lubricant, and antiblocking agent. Examples of pigment include titanium dioxide, carbon black and other appropriate materials. Examples of ultraviolet absorber include benzophenone-based, benzotriazole-based, oxanilide-based, cyanoacrylate-based, and triazine-based ones.

In order to improve peel resistance from the thermoplastic resin layer 12A, the surface of the resin film to be laminated thereon with the thermoplastic resin layer 12A may preferably be subjected to surface treatment, such as corona treatment, plasma treatment and primer treatment.

The thickness of the substrate 11 may appropriately be set on the basis of the electrical insulation property, water vapor barrier property and other factors required for the solar cell module. For example, when the substrate 11 is a resin film, it may be preferred that the thickness thereof is 10 to 300 µm. More specifically, when the substrate 11 is a PET film, in view of the electrical insulation property and the weight saving, the thickness thereof may be preferably 10 to 300 µm, more preferably 20 to 250 µm, and most preferably 30 to 200 µm.

The thermoplastic resin layer 12A in the present embodiment is a layer for causing the protective sheet 1A to adhere to the encapsulant of the solar cell module, but the present invention is not limited thereto. The thermoplastic resin layer 12A in the present embodiment may comprise a single layer and contain a thermoplastic resin as a main component, and further contains one or more pigments.

Examples of pigment include titanium oxide, talc, magnesium oxide, cerium oxide, barium sulfate, calcium carbonate and carbon black, among which one may be solely used or two or more may be used in combination.

If the thermoplastic resin layer 12A contains the above pigment, then, even in the case where the thermoplastic resin layer 12A is formed on the substrate 11 by extrusion coating, the pigment may get into the crystal structure when the thermoplastic resin is crystallized and the thermoplastic resin may be restrained by the pigment so that the thermoplastic resin layer 12A is unlikely to contract when cooled from the heated and molten state, thus the curl amount of the protective sheet 1A may be small. This can suppress the warping of the solar cell module due to the curl of the protective sheet 1A. More specifically, according to the protective sheet 1A that comprises the thermoplastic resin layer 12A containing the above pigment, the curl amount thereof can be suppressed to 20 mm or less in consideration of a general assumption that, when a square-shaped sample of 300 mm×300 mm is cut out from the protective sheet 1A to be placed on a horizontal table, a curl amount of 20 mm or less in the vertical direction ensures that the warping of the solar cell module is suppressed.

Among the above pigments, titanium oxide may be preferable as white pigment while carbon black as black pigment in view of chromogenic property, availability and cost, etc.

The particle diameter of pigment is not particularly limited, but the average particle diameter may be preferably 0.005 to 10 µm, and particularly preferably 0.01 to 5 µm.

The thermoplastic resin layer 12A may preferably contain 2.5 to 35 mass% of the pigment, particularly preferably 2.5 to 32.5 mass%, and further preferably 3.0 to 30 mass%. When titanium oxide is used as the pigment, the thermoplastic resin layer 12A may preferably contain 3.0 to 30 mass% of titanium oxide, particularly preferably 5.0 to 25 mass%, and further preferably 7.5 to 20 mass%. When carbon black is used as the pigment, the thermoplastic resin layer 12A may preferably contain 2.5 to 30 mass% of carbon black, particularly preferably 2.75 to 25 mass%, and further preferably 3.0 to 20 mass%.

The content of the pigment being the above lower limit value or more may allow the curl amount of the protective sheet 1A to be suppressed to a small amount, and also allow the thermoplastic resin layer 12A to sufficiently have a desired color and reflectance. The content of the pigment being the above upper limit value or less may allow the thermoplastic resin layer 12A to maintain adhesiveness to the encapsulant of the solar cell module.

The thermoplastic resin layer 12A in the present embodiment may contain a thermoplastic resin as the main component, in which case the thermoplastic resin has thermally adhesive functionality, so that the thermoplastic resin layer 12A may have high adhesiveness to the encapsulant of the solar cell module.

It may be preferred that the thermoplastic resin as the main component of the thermoplastic resin layer 12A is an olefin-based resin that has a density of 875 to 920 kg/m³, in particular 880 to 915 kg/m³, and a heat (enthalpy) of fusion ΔH measured with a differential scanning calorimeter of 100 J/g or less, in particular 95 J/g or less. The density may be a value obtained by measurement according to JIS K7112: 1999. The lower limit value of the heat of fusion ΔH may be determined in itself according to the relationship with the density and the skeleton of each resin, but may preferable be zero in theory.

Olefin-based resin, which has a low or very low density and a low heat of fusion ΔH as described above and thus low crystallinity, is with a small contraction rate even when cooled from the heated and molten state. Therefore, if the olefin-based resin is used as the main component of the thermoplastic resin layer 12A, then, even in the case where the thermoplastic resin layer 12A is formed on the substrate 11 by extrusion coating, stress is unlikely to be caused to act toward the substrate 11, so that the protective sheet 1A may have less curl amount. This may allow the solar cell module to be more effectively suppressed from warping due to the curl of the protective sheet 1A.

If the density of the olefin-based resin is less than 875 kg/m³, then tucks may occur in the thermoplastic resin layer 12A to cause blockings in the rolled-up protective sheet 1A, and blocking traces may occur on the surface of the protective sheet 1A and/or the rolled-up protective sheet 1A may not be unrolled. If the density of the olefin-based resin exceeds 920 kg/m³ and/or the heat of fusion ΔH of the olefin-based resin exceeds 100 J/g, then the protective sheet 1A may tend to have a large curl amount (but the curl may be suppressed by compounding the above pigment).

Melt flow rate (MFR) of the above olefin-based resin may be preferably within a range of 1 to 20 g/10 min, and particularly preferably within a range of 2 to 10 g/10 min. The MFR of the olefin-based resin being within the above range may allow the thermoplastic resin layer 12A to be formed by extrusion coating.

Examples of the olefin-based resin include polyethylene resin such as low density polyethylene (LDPE, density: 910 kg/m³ or more and less than 930 kg/m³) and very low density polyethylene (VLDPE, density: 880 kg/m³ or more and less than 910 kg/m³), polypropylene resin (PP), polyethylene-polypropylene copolymer, olefin-based elastomer (TPO), cycloolefin resin, ethylene-vinyl acetate copolymer (EVA), ethylene-vinyl acetate-maleic anhydride copolymer, ethylene-(meth)acrylic acid copolymer, ethylene-acrylic acid ester copolymer, and ethylene-(meth)acrylic acid ester-maleic anhydride copolymer, among which one may be solely used or two or more may be used after being mixed. The term of (meth)acrylic acid as used herein refers both acrylic acid and methacrylic acid. The same applies to other similar terms.

Among the above olefin-based resins, polyethylene-based resin may be preferable which contains 60 to 100 mass%, particularly 70 to 99.5 mass% of ethylene as a monomer unit, and very low density polyethylene may further be preferable which contains 60 to 100 mass%, particularly 70 to 99.5 mass% of ethylene as a monomer unit. Such a polyethylene-based resin may have excellent working suitability and high affinity with the encapsulant of the solar cell module, in particular with an encapsulant formed of ethylene-vinyl acetate copolymer which is the same ethylene-based, and thus exhibit significantly excellent adhesiveness.

The thermoplastic resin layer 12A may preferably contain 60 mass% or more of the previously-described olefin-based resin, more preferably 80 mass% or more, and most preferably 90 mass% or more.

The thermoplastic resin layer 12A may contain, as necessary, various additives, such as ultraviolet absorber, ultraviolet stabilizer, flame retardant, plasticizer, antistatic agent, lubricant, and antiblocking agent.

The thickness of the thermoplastic resin layer 12A may not particularly be restricted so long as exhibiting desired adhesiveness to the adherend without impairing the advantageous effects of the present invention. More specifically, the thickness of the thermoplastic resin layer 12A may be preferably 1 to 200 µm, more preferably 10 to 180 µm in view of the electrical insulation property and the weight saving, particularly preferably 50 to 150 µm, and further preferably 80 to 120 µm.

The thermoplastic resin layer 12A in the present embodiment may comprise a single layer thereby to have advantages in material cost and production cost.

As shown in FIG. 2, it may be preferred that a fluorine resin layer 13 is provided on the surface (lower surface in FIG. 2) of the substrate 11 at the side where the above thermoplastic resin layer 12A is not laminated. Providing the fluorine resin layer 13 in such a manner may improve the weatherability and chemical resistance of the protective sheet 1A. When the substrate 11 is formed of a resin film, the surface of the resin film to be laminated thereon with the fluorine resin layer 13 may preferably be subjected to surface treatment, such as corona treatment, plasma treatment and primer treatment, in order to improve peel resistance from the fluorine resin layer 13.

The fluorine resin layer 13 is not particularly restricted if containing fluorine, and may be configured of a sheet having fluorine-containing resin (fluorine-containing resin sheet) or a coating obtained by applying a paint that includes fluorine-containing resin, for example. Among them, the coating obtained by applying a paint that includes fluorine-containing resin may be preferable in view of reducing the thickness of the fluorine resin layer 13 for the purpose of weight saving of the protective sheet 1A .

The fluorine-containing resin sheet includes, for example, a sheet-like resin mainly containing polyvinyl fluoride (PVF), ethylene-chlorotrifluoroethylene (ECTFE) or ethylene-tetrafluoroethylene (ETFE). The resin mainly containing PVF includes, for example, "Tedlar" (trade name) available from DuPont. The resin mainly containing ECTFE includes, for example, "Halar" (trade name) available from Solvay Solexis, Inc. The resin mainly containing ETFE includes, for example, "Fluon" (trade name) available from ASAHI GLASS CO., LTD.

If the fluorine resin layer 13 is a fluorine-containing resin sheet, the fluorine resin layer 13 may be laminated on the substrate 11 via an adhesive layer. The adhesive layer may be comprised of an adhesive that has adhesiveness to the substrate 11 and the fluorine-containing resin sheet. Examples of such an adhesive to be used include acrylic-based adhesive, polyurethane-based adhesive, epoxy-based adhesive, polyester-based adhesive, and polyester polyurethane-based adhesive. One of these adhesives may be solely used or two or more may be used in combination.

If the fluorine resin layer 13 is a coating obtained by applying a paint that includes fluorine-containing resin, then the fluorine resin layer 13 may be laminated on the substrate 11 by applying the paint, which contains fluorine-containing resin, directly to the substrate 11 ordinarily without any adhesive layer.

The paint that contains fluorine-containing resin is not particularly limited if being dissolved into solvent or dispersed into water and capable of being applied.

The fluorine-containing resin to be contained in the paint is not particularly limited if being a resin that contains fluorine without impairing the advantageous effects of the present invention, and a resin may ordinarily be used which dissolves into solvent of the paint (organic solvent or water) and which is crosslinkable. It may be preferred that a fluoroolefin resin having a crosslinkable functional group is used as the fluorine-containing resin. Examples of crosslinkable functional group include hydroxyl group, carboxyl group, amino group, and glycidyl group.

Specific examples of fluoroolefin resin having crosslinkable functional group include polymers, such as "LUMIFLON" (trade name) available from ASAHI GLASS CO., LTD, "CEFRAL COAT" (trade name) available from Central Glass Co., Ltd. and "FLUONATE" (trade name) available from DIC Corporation, which contain chlorotrifluoroethylene (CTFE) as the main component, and polymers, such as "ZEFFLE" (trade name) available from DAIKIN INDUSTRIES, LTD, which contain tetrafluoroethylene (TFE) as the main component. Among them, in view of weatherability and pigment dispersibility, etc, a polymer that contains CTFE as the main component and a polymer that contains TFE as the main component may be preferred, and "LUMIFLON" and "ZEFFLE" may particularly be preferred.

The paint may contain cross-linking agent, curing catalyst, solvent and other appropriate agents in addition to the above fluorine-containing resin, and may further contain inorganic compounds, such as pigment and filler, if necessary.

The coating of the fluorine-containing resin may preferably be crosslinked by using a cross-linking agent in order to improve the weatherability and abrasion-resistant ability. The cross-linking agent is not particularly limited so long as not impairing the advantageous effects of the present invention, and metal chelates, silanes, isocyanates or melamines may be preferably used. On the assumption that the protective sheet 1A will be placed outdoors and used for long period of time, aliphatic isocyanates of cross-linking agent may be preferable in view of weatherability.

Any known method may be used as the method of applying the paint to the substrate 11, and the paint may be applied to the substrate 11 so that the fluorine resin layer 13 with desired thickness is obtained, for example, using bar-coating, knife-coating, roll-coating, blade-coating, die-coating, gravure-coating, or other appropriate method.

The thickness of the fluorine resin layer 13, which will be set with consideration for the weatherability, chemical resistance, weight saving and other factors, may be preferably 5 to 50 µm, and particularly preferably 10 to 30 µm.

The fluorine resin layer 13 may also be comprised of thermoplastic material, in which case the fluorine resin layer 13 can be formed by extrusion coating method rather than by application of a paint. Such a fluorine resin layer 13 may be formed directly on the substrate 11 by extrusion coating, or otherwise formed on the substrate 11 via one or more additional layers that can enhance the adhesion to the substrate 11. For example, as shown in FIG. 3, a second thermoplastic resin layer 12C may be interposed between the fluorine resin layer 13 and the substrate 11. In this case, co-extrusion coating may preferably be performed such that the second thermoplastic resin layer 12C and the fluorine resin layer 13 are formed on the substrate 11.

The fluorine resin layer 13 comprising thermoplastic material include, for example, resins mainly containing ethylene-tetrafluoroethylene-based copolymer (ETFE), ethylene-chlorotrifluoroethylene-based copolymer, ethylene-tetrafluoroethylene-hexafluoropropylene-based copolymer, tetrafluoroethylene-perfluoro (alkyl vinyl ether)-based copolymer, tetrafluoroethylene-hexafluoropropylene-based copolymer, tetrafluoroethylene-perfluoro (alkyl vinyl ether)-hexafluoropropylene-based copolymer or other copolymer, or modified polymer thereof. One of these resins may be solely used or two or more may be mixed to use. The fluorine resin layer 13 comprising thermoplastic material may have high weatherability as advantages. Among the above resins, ETFE may particularly be preferable in view of peel resistance from the substrate 11 or to the second thermoplastic resin layer 12C.

The second thermoplastic resin layer 12C include, for example, polyethylene such as low density polyethylene (LDPE, density: 910 kg/m³ or more and less than 930 kg/m³), middle density polyethylene (MDPE, density: 930 kg/m³ or more and less than 942 kg/m³) and high density polyethylene (HDPE, density: 942 kg/m³ or more), polypropylene (PP), olefin-based elastomer (TPO), cycloolefin-based resin, ethylene-vinyl acetate copolymer (EVA), ethylene-vinyl acetate-maleic anhydride copolymer, ethylene-(meth)acrylic acid copolymer, ethylene-(meth)acrylic acid ester copolymer, ethylene-(meth)acrylic acid ester-maleic anhydride copolymer, and ethylene-glycidyl (meth)acrylate copolymer. One of these resins may be solely used or two or more may be used after being mixed. Among them, ethylene-vinyl acetate-maleic anhydride copolymer and ethylene-glycidyl methacrylate copolymer (EGMA) may be particularly preferable. Such a resin has a functional group and therefore polarity, thus exhibiting large adhesion to the substrate 11, particularly to the substrate 11 comprising a resin film, and further to the substrate 11 comprising a PET film. Among the above resins, EGMA may particularly be preferable because of excellent adhesiveness both to the fluorine resin layer 13, which comprises fluorine resin containing a functional group, and to the substrate 11 comprising PET etc.

The thickness of the second thermoplastic resin layer 12C is not particularly restricted so long as exhibiting desired adhesiveness to the substrate 11 without impairing the advantageous effects of the present invention. More specifically, the thickness of the second thermoplastic resin layer 12C may be preferably 2 to 100 µm, particularly preferably 5 to 75 µm, and further preferably 10 to 50 µm.

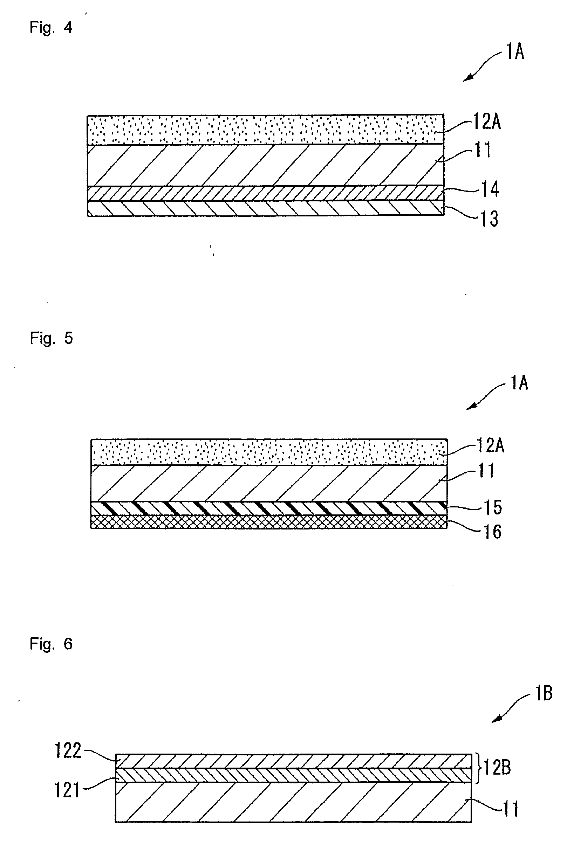

If the substrate 11 is formed of a resin film, the surface of the substrate 11 at the side where the above thermoplastic resin layer 12A is not laminated may be provided with a vapor-deposited layer 14 between the substrate 11 and the fluorine resin layer 13 as shown in FIG. 4, or provided with a metal sheet 16 via an adhesive layer 15 as shown in FIG. 5, or the above-described fluorine resin layer 13 may also be provided on the surface of the vapor-deposited layer 14 or the metal sheet 16 (each lower surface in FIG. 4 and FIG. 5). Providing the vapor-deposited layer 14 or the metal sheet 16 in such a manner may improve the moisture-proof property and the weatherability of the protective sheet 1A.

The surface of the resin film substrate 11 at the side where the vapor-deposited layer 14 or the adhesive layer 15 is to be laminated thereon may preferably be subjected to surface treatment, such as corona treatment, plasma treatment and primer treatment, in order to improve peel resistance from the vapor-deposited layer 14 or the adhesive layer 15.

The vapor-deposited layer 14 may comprise inorganic material, such as metal or semimetal, oxide of metal or semimetal, nitride and silicide, thereby allowing the substrate 11 (protective sheet 1A) to have the moisture-proof property (water vapor barrier property) and the weatherability.

The vapor deposition method used for forming the vapor-deposited layer 14 include, for example, chemical vapor phase method such as plasma-enhanced chemical vapor deposition method, thermochemical vapor deposition method and photochemical vapor deposition method, and physical vapor phase method such as vacuum vapor deposition method, sputtering method and ion plating method. Among these methods, sputtering method may be preferable in consideration of operability and controllability for the layer thickness.

The metal for raw materials of the vapor-deposited layer 14 include, for example, aluminum (Al), magnesium (Mg), calcium (Ca), potassium (K), tin (Sn), sodium (Na), titanium (Ti), lead (Pb), zirconium (Zr), and yttrium (Y). The semimetal includes, for example, silicon (Si) and boron (B). The oxide, nitride or oxynitride of these metals or semimetals include, for example, aluminum oxide, tin oxide, silicon oxide, silicon nitride, silicon oxynitride, and aluminum oxynitride.

The vapor-deposited layer 14 may comprise one of inorganic material or plural of inorganic materials. When the vapor-deposited layer 14 comprises plural of inorganic materials, it may be a vapor-deposited layer laminated in which each layer made of single inorganic material is sequentially vapor-deposited, or a vapor-deposited layer in which the plural inorganic materials are vapor-deposited simultaneously.

The thickness of the vapor-deposited layer 14 may appropriately be set with consideration for the water vapor barrier property and changed depending on the type of inorganic material to be used, vapor deposition density and other factors. Typically, the thickness of the vapor-deposited layer 14 may be preferably 5 to 200 nm, and particularly preferably 10 to 100 nm.

Like the vapor-deposited layer 14, the metal sheet 16 may also allow the substrate 11 (protective sheet 1A) to have the moisture-proof property (water vapor barrier property) and the weatherability. Material for the metal sheet 16 is not particularly restricted so long as having such functions, and examples thereof include aluminum, aluminum alloy such as aluminum-iron alloy, and other appropriate metals.

While the thickness of the metal sheet 16 is not particularly limited so long as not impairing the advantageous effects of the present invention, the thickness may be preferably 5 to 100 µm, and particularly preferably 10 to 50 µm, from the aspect of lower occurrence frequency of pinholes, higher mechanical strength, higher water vapor barrier property, weight saving and other factors.

The adhesive layer 15 may comprise an adhesive that has adhesiveness to the substrate 11 and the metal sheet 16. Examples of the adhesive contained in the adhesive layer 15 include acrylic-based adhesive, polyurethane-based adhesive, epoxy-based adhesive, polyester-based adhesive, and polyester polyurethane-based adhesive. One of these adhesives may be solely used or two or more may be used in combination.

While the thickness of the adhesive layer 15 is not particularly limited so long as not impairing the advantageous effects of the present invention, typically the thickness may be preferably 1 to 20 µm, and particularly preferably 3 to 10 µm.

The above embodiments may have exemplified the protective sheet 1A in which the thermoplastic resin layer 12A is laminated on one surface of the substrate 11, but the solar cell protective sheet of the present invention is not limited thereto, and a thermoplastic resin layer may also be laminated on the other surface of the substrate 11 (opposite surface to the above one surface).

### «Solar cell protective sheet (2)»

As shown in FIG. 6, protective sheet 1B according to the second embodiment may comprise, like in the protective sheet 1A according to the first embodiment, a substrate 11 and a thermoplastic resin layer 12B laminated on one surface (upper surface in FIG. 6) of the substrate 11, but the thermoplastic resin layer 12B may be configured of two layers, i.e., a first layer 121 laminated on the substrate 11 and a second layer 122 laminated on the first layer 121.

The second layer 122 may be formed of the same material as that of the protective sheet 1A according to the first embodiment. The second layer 122 may therefore contain a thermoplastic resin, preferably the previously-described olefin-based resin, as the main component, and further contains the previously-described pigment.

The second layer 122 may preferably contain 2.5 to 35 mass% of the pigment, particularly preferably 2.5 to 32.5 mass%, and further preferably 3.0 to 30 mass%. When titanium oxide is used as the pigment, the second layer 122 may preferably contain 3.0 to 30 mass% of titanium oxide, particularly preferably 5.0 to 25 mass%, and further preferably 7.5 to 20 mass%. When carbon black is used as the pigment, the second layer 122 may preferably contain 2.5 to 30 mass% of carbon black, particularly preferably 2.75 to 25 mass%, and further preferably 3.0 to 20 mass%.

The thickness of the second layer 122 may be preferably 10 to 200 µm, particularly preferably 15 to 150 µm, and further preferably 25 to 125 µm.

The first layer 121 may be formed of a material that exhibits adhesiveness to the substrate 11. The first layer 121 being formed of a material that exhibits adhesiveness to the substrate 11 may allow the protective sheet 1B according to the present embodiment to have excellent adhesiveness between the substrate 11 and the thermoplastic resin layer 12B. The second layer 122 may have a large adhesion to the encapsulant of the solar cell module due to excellent thermally adhesive functionality of the thermoplastic resin, in particular of the previously-described olefin-based resin. These large adhesions may ensure that the protective sheet 1B according to the present embodiment is unlikely to delaminate, and the interior of the solar cell module can thereby be protected for long period of time.

It is preferred that the first layer 121 contains, as the main component, a copolymer of ethylene and at least one selected from the group consisting of (meth)acrylic acid, (meth)acrylic acid ester and vinyl acetate (the copolymer may hereinafter be referred to as "copolymer F"). The first layer 121 comprising the above materials may have a large adhesion to the substrate 11, particular to the substrate 11 comprising a resin film, and further to the substrate 11 comprising a PET film.

The above copolymer F may have a large adhesive force to the substrate 11, particular to the substrate 11 comprising a resin film, and further to the substrate 11 comprising a PET film. The above copolymer F may be amorphous (non-crystalline) at ordinary temperatures and have elasticity. Therefore, even if the second layer 122 would contract when cooled from the heated and molten state (although the contained pigment may suppress the contraction), the first layer 121 which contains the copolymer F as the main component can relax the contraction stress. As such, even in the case where the first layer 121 and the second layer 122 are formed on the substrate 11 by co-extrusion coating, stresses are unlikely to be caused to act toward the substrate 11, and the curl amount of the protective sheet 1B can thus be reduced.

The first layer 121 may preferably contain, as the main component, a copolymer of ethylene and (meth)acrylic acid, a copolymer of ethylene and (meth)acrylic acid ester, or a copolymer of ethylene and vinyl acetate, among which one may be solely used or two or more may be used in combination.

As the (meth)acrylic acid ester, alkyl (meth)acrylate ester may be preferable in which the carbon number of the alkyl group is 1 to 18, and examples thereof include methyl (meth)acrylate, ethyl (meth)acrylate, propyl (meth)acrylate, butyl (meth)acrylate, and 2-ethylhexyl acrylate, among which methyl acrylate and butyl acrylate may be preferable. One of them may be solely used or two or more may be used in combination.

It may particularly be preferred that the first layer 121 contains, as the main component, ethylene-methacrylic acid copolymer, ethylene-butyl acrylate copolymer, ethylene-methyl acrylate copolymer or ethylene-vinyl acetate copolymer, among which one type may be solely used or two or more may be used in combination.

The total content of (meth)acrylic acid, (meth)acrylic acid ester and vinyl acetate as a monomer unit in the above copolymer F may be preferably 2 to 40 mass%, and particularly preferably 3 to 35 mass%. More specifically, the content of (meth)acrylic acid in the copolymer of ethylene and (meth)acrylic acid, the content of (meth)acrylic acid ester in the copolymer of ethylene and (meth)acrylic acid ester, and/or the content of vinyl acetate in the copolymer of ethylene and vinyl acetate, may be preferably 2 to 40 mass%, and particularly preferably 3 to 35 mass%.

When the total content of (meth)acrylic acid, (meth)acrylic acid ester and vinyl acetate may be within the above range, the large adhesion to the substrate 11 and curl suppressing effect mentioned above will be more significant. If the total content of (meth)acrylic acid, (meth)acrylic acid ester and vinyl acetate is less than 2 mass%, then adhesions to the substrate 11 and the second layer 122 may be reduced, while if the total content is 40 mass% or more, then sufficient aggregation force cannot be obtained and irregularities in winding may possibly occur when the protective sheet 1B is rolled up.

It may be preferred that the first layer 121 contains the copolymer F as the main component, in particular, the copolymer F may be preferably contained with 60 mass% or more, particularly preferably with 80 mass% or more, and further preferably with 90 mass% or more. The first layer 121 may consist only of the copolymer F.

The first layer 121 may contain, as necessary, in addition to the above resin as the main component, various additives, such as ultraviolet absorber, ultraviolet stabilizer, flame retardant, plasticizer, antistatic agent, lubricant, and antiblocking agent. If, however, the first layer 121 contains pigment, then adhesiveness may deteriorate so that peel resistance from the substrate 11 may possibly be poor, and hence it may be preferred that the first layer 121 is free from pigment.

The thickness of the first layer 121 may be preferably 5 to 150 µm, particularly preferably 10 to 100 µm, and further preferably 15 to 75 µm.

The ratio of the thickness of the first layer 121 and the thickness of the second layer 122 may be preferably within a range of 1:9 to 7:3, particularly preferably within a range of 1.5:8.5 to 6.5:3.5, and further preferably within a range of 2:8 to 6:4. The ratio of the thickness of the first layer 121 and the thickness of the second layer 122 being within the above range may allow the protective sheet 1B according to the present embodiment to have less curl amount.

Each melt flow rate (MFR) of the constituent resin (copolymer F) in the first layer 121 and the olefin-based resin in the second layer 122 may be preferably within a range of 1 to 20 g/10 min, and particularly preferably within a range of 2 to 10 g/10 min. The MFRs of both resins being within the above range may allow the first layer 121 and the second layer 122 to be formed by co-extrusion coating.

The thermoplastic resin layer 12B in the present embodiment may consist of the first layer 121 and the second layer 122, but the present invention is not limited thereto, and one or more additional layers may be provided so long as not impairing the advantageous effects of the present invention. For example, a third layer may be provided between the first layer 121 and the second layer 122.

Like in the protective sheet 1A according to the first embodiment, the protective sheet 1B according to the present embodiment may further comprise other layers, such as fluorine resin layer 13, second thermoplastic resin layer 12C, vapor-deposited layer 14, adhesive layer 15 and metal sheet 16.

### «Producing method of solar cell protective sheet»

In order to produce the protective sheet 1A according to the above first embodiment (as one example, the protective sheet 1A shown in FIG. 1), it may be preferred that molten resin composition of the thermoplastic resin layer 12A is extruded to laminate on at least one surface of the substrate 11 and form the thermoplastic resin layer 12A on the substrate 11.

Specifically, using a T-die extruder, a T-die film forming machine, or the like, the resin composition forming the thermoplastic resin layer 12A is molten and mixed moving the substrate 11 with constant speed, the molten resin is extruded and laminated on one surface of the substrate 11 to form the thermoplastic resin layer 12A on the substrate 11.

In order to produce the solar cell protective sheet 1B according to the above second embodiment (as one example, the solar cell protective sheet 1B shown in FIG. 6), it may be preferred that a first resin composition constituting the first and layer 121 of the above thermoplastic resin layer 12B and a second resin composition constituting the second layer 122 were co-extruded to coat onto at least one surface of the substrate 11 so as to locate the first resin composition at the side of the substrate 11, then to form the thermoplastic resin layer 12B comprising the first layer 121 laminated on the substrate 11 and the second layer 122 laminated on the first layer 121.

Specifically, using a T-die film forming machine or the like, the first and second resin compositions are molten and mixed, respectively; moving the substrate 11 with constant speed, the first resin composition and the second resin composition are co-extruded to laminate on one surface of the substratell; then the thermoplastic resin layer 12B comprising the first layer 121 and the second layer 122 is formed on the substrate 11 to obtain the solar cell protective sheet 1B.

Such a (co-)extrusion coating method as described above may allow the solar cell protective sheet 1 to be produced with high productivity at low cost. Since an adhesive layer needs not be separately provided for causing the solar cell protective sheet 1A, 1B to adhere to the encapsulant of the solar cell module, time degradation such as due to decomposition of that adhesive can be prevented.

As shown in FIG. 2 to FIG. 5, if an additional layer is formed on the substrate 11, the thermoplastic resin layer 12A, 12B may be formed on the surface at the side with no additional layers.

Temperature for melting the resin composition forming the thermoplastic resin layer 12A, 12B may be set as being such a degree that does not deform the substrate 11 due to the temperature (heat) of the molten resin composition, and the temperature may be preferably 80°C to 350°C, and particularly preferably 150°C to 300°C.

Discharge rate from the T-die film forming machine for the resin composition that forms the thermoplastic resin layer 12A, 12B may appropriately be adjusted depending on the intended thickness of the thermoplastic resin layer 12A, 12B and/or the moving speed of the substrate 11.

The substrate 11, for example, may be moved (carried) in the longitudinal direction with constant speed by roll-to-roll process. The moving speed may appropriately be adjusted depending on the discharge rate from the T-die film forming machine for the resin composition that forms the thermoplastic resin layer 12A, 12B.

According to the (co-)extrusion coating method described above, the thermoplastic resin layer 12A, 12B can be tightly bonded to the substrate 11 simply by performing the (co-)extrusion coating of the molten resin composition or compositions from the T-die film forming machine to be laminated on one surface of the substrate 11, and the solar cell protective sheet 1A, 1B can thus be produced with high productivity.

### «Solar cell module»

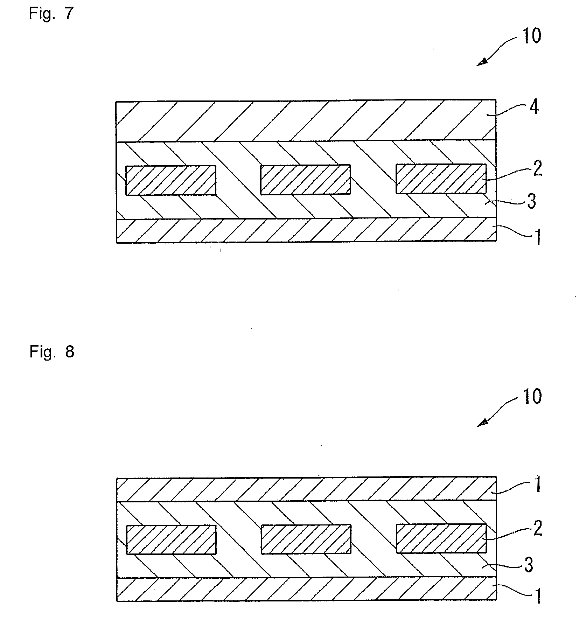

FIG. 7 is a schematic cross-sectional view of a solar cell module according to one embodiment of the present invention. Solar cell module 10 according to the present embodiment may be configured of: plural solar cells 2 as photoelectric conversion elements, each comprising crystal silicon, amorphous silicon and/or other appropriate material; an encapsulant (filling layer) 3, comprising electrical insulator, which encapsulates the solar cells 2; a glass plate 4 laminated on the front surface (upper surface in FIG. 7) of the encapsulant 3; and the solar cell protective sheet 1 (the solar cell protective sheet 1A, 1B in the above embodiments), as a back surface solar cell protective sheet (back sheet), laminated on the back surface (lower surface in FIG. 7) of the encapsulant 3.

The solar cell protective sheet 1 may be laminated on the encapsulant 3 so that the thermoplastic resin layer 12A or the second layer 122 of the thermoplastic resin layer 12B is in contact with the encapsulant 3, and hence the adhesion to the encapsulant 3 may be high due to those layers that contain thermoplastic resin, preferably the olefin-based resin mentioned above, as the main component. In particular, if the solar cell protective sheet 1B is used as the solar cell protective sheet 1, then adhesiveness between the substrate 11 and the thermoplastic layer 12B may also be excellent. Due to these large adhesions, the interior of the solar cell module 10 according to the present embodiment can be protected by the solar cell protective sheet 1 for long period of time. The solar cell protective sheet 1 according to the present embodiment may also exhibit less curl amount, so that the obtained solar cell module 10 can be suppressed from warping. Consequently, the solar cell module 10 can be prevented from troubles that may occur at the time of installing the solar cell module 10, and/or from being damaged, due to the warpage of the solar cell module 10.

Material for the encapsulant 3 may preferably be olefin-based resin, such as olefin-based resin exemplified as the main component in the thermoplastic resin layer 12A or the second layer 122 of the thermoplastic resin layer 12B, and more preferably ethylene-vinyl acetate copolymer (EVA) in view of high gas barrier property for oxygen and other problematic gasses, easy cross-linkage, and availability etc. The material for the encapsulant 3 being olefin-based resin may ensure the high affinity with the thermoplastic resin layer 12A or the second layer 122 of the thermoplastic resin layer 12B, which contains olefin-based resin as the main component, thereby further enhancing the adhesion between the thermoplastic resin layer 12A, 12B and the encapsulant 3.

Producing method of the above solar cell module 10 may not be particularly limited, and the solar cell module 10 can be produced, for example, through: sandwiching the solar cells 2 between two sheets that constitute the encapsulant 3; placing the solar cell protective sheet 1 on one exposed surface of those sheets; placing the glass plate 4 on the other exposed surface of those sheets; and integrating them by pressing while heating them. According to this method, the solar cell protective sheet 1 may be bonded to the encapsulant 3 by the thermal fusion bonding between the thermoplastic resin layer 12A, 12B and the encapsulant 3.

As shown in FIG. 8, a solar cell protective sheet 1 as the front surface solar cell protective sheet (front sheet) may be used as a substitute for the glass plate 4. In this case, if flexible substrates are used for the solar cells 2, a solar cell module that has flexibility can be obtained. Causing the solar cell module to have flexibility in such a manner may enable mass production via roll-to-roll process. As the solar cell module having flexibility can be fitted to an object that has arch-shaped or parabolic-shaped wall surface, the solar cell module can be installed on domed buildings or sound abatement walls of expressway.

It should be appreciated that the embodiments heretofore explained are described to facilitate understanding of the present invention and are not described to limit the present invention. Therefore, it is intended that the elements disclosed in the above embodiments include all design changes and equivalents to fall within the technical scope of the present invention.

### [Examples]

The present invention will hereinafter be described further specifically with reference to examples etc, but the scope of the present invention is not limited to these examples etc.

### «Example 1»

One surface of a PET film (trade name: Melinex S, available from Teijin DuPont Films Japan Limited, thickness 125 µm) as a substrate was subjected to corona treatment (output 2,000 W). Using a T-die film forming machine, mixture of 97.5 parts by mass of polyethylene-based resin (trade name: LUMITAC 43-1, available from TOSOH CORPORATION, density: 905 kg/m³, heat of fusion ΔH: 79 J/g) and 2.5 parts by mass of titanium oxide as pigment (trade name: TIPAQUE CR-60, available from ISHIHARA SANGYO KAISHA, LTD., average particle diameter: 0.21 µm) was molten at 300°C, extruded to have a thickness of 150 µm onto the corona treated surface of the above PET film, then formed a thermoplastic resin layer to obtain a solar cell protective sheet shown in FIG. 1.

The density of the above polyethylene-based resin was measure according to JIS K7112: 1999. The heat of fusion ΔH of the above polyethylene-based resin was measured in a manner as below.

### <Measurement of heat of fusion>

For the above polyethylene-based resin, a differential scanning calorimeter (model number: Q2000, available from TA Instruments Japan Inc.) was used to perform measurement of change in heat quantity under the following conditions for sampling data.

### -Sample adjustment condition

Heating was performed with a rate of temperature rise of 20°C/min from -40°C to 250°C.

### -Measurement condition

After waiting at 250°C during 5 minutes, cooling was performed with a rate of temperature fall of 20°C/min to -40°C while measuring the change in heat quantity.

The obtained data was used to calculate the area of a peak due to solidification, which would represent the heat of fusion ΔH (J/g).

### «Example 2»

A solar cell protective sheet was obtained in the same manner as Example 1 with the exception of changing the compounding amount of the polyethylene-based resin to 85.0 parts by mass and the compounding amount of the titanium oxide to 15.0 parts by mass.

### «Example 3»

A solar cell protective sheet was obtained in the same manner as Example 1 with the exception of changing the compounding amount of the polyethylene-based resin to 65.0 parts by mass and the compounding amount of the titanium oxide to 35.0 parts by mass.

### «Example 4»

A solar cell protective sheet was obtained in the same manner as Example 2 with the exception of substituting the titanium oxide by magnesium oxide (trade name: #500, available from Tateho Chemical Industries Co., Ltd., average particle diameter: 5 µm).

### «Example 5»

A solar cell protective sheet was obtained in the same manner as Example 2 with the exception of substituting the titanium oxide by cerium oxide (trade name: Nano Tek CeO₂, available from C. I. Kasei Company, Limited, average particle diameter: 0.012 µm).

### «Example 6»

A solar cell protective sheet was obtained in the same manner as Example 2 with the exception of substituting the titanium oxide by talc (trade name: MICRO ACE P-3, available from Nippon Talc Co.,Ltd., average particle diameter: 5.0 µm).

### «Example 7»

A solar cell protective sheet was obtained in the same manner as Example 2 with the exception of substituting the titanium oxide by calcium carbonate (trade name: NN#500, available from NITTO FUNKA KOGYO K.K., average particle diameter: 4.4 µm).

### «Example 8»

A solar cell protective sheet was obtained in the same manner as Example 1 with the exception of substituting the titanium oxide by carbon black (trade name: #45L, available from Mitsubishi Chemical Corporation, average particle diameter: 0.024 µm), and changing the compounding amount of the polyethylene-based resin to 97.0 parts by mass and the compounding amount of the pigment (carbon black) to 3.0 parts by mass.

### «Example 9»

One surface of a PET film (trade name: Melinex S, available from Teijin DuPont Films Japan Limited, thickness 125 µm) as a substrate was subjected to corona treatment (output 2,000 W). Using a T-die film forming machine, ethylene-butyl acrylate copolymer (trade name: LOTRYL 30BA02, available from Arkema, content of butyl acrylate: 30 mass%, referred hereinafter to as "copolymer A") and a mixture of 85.0 parts by mass of polyethylene-based resin (trade name: LUMITAC 43-1, available from TOSOH CORPORATION, density: 905 kg/m³) and 15.0 parts by mass of titanium oxide as pigment (trade name: TIPAQUE CR-60, available from ISHIHARA SANGYO KAISHA, LTD., average particle diameter: 0.21 µm) were molten at 300°C, respectively; co-extruded directly on the corona treated surface of the PET film to have thicknesses of 40 µm and 110 µm, respectively, and to locate the co-polymer A at the side of the substrate; then formed a thermoplastic resin layer comprising a first layer (copolymer A: thickness 40 µm) and a second layer (polyethylene-based resin having a density of 905 kg/m³: thickness 110 µm) to obtain a solar cell protective sheet shown in FIG. 6.

### «Example 10»

A solar cell protective sheet was obtained in the same manner as Example 9 with the exception of substituting the titanium oxide in the second layer by carbon black (trade name: #45L, available from Mitsubishi Chemical Corporation, average particle diameter: 0.024 µm), and changing the compounding amount of the polyethylene-based resin to 97.0 parts by mass and the compounding amount of the pigment (carbon black) to 3.0 parts by mass.

### «Comparative Example 1»

A solar cell protective sheet was obtained in the same manner as Example 1 with the exception of compounding no titanium oxide and changing the compounding amount of the polyethylene-based resin to 100.0 parts by mass.

### «Exemplary Test 1» <Curl amount measurement>

A test piece was prepared by cutting each of the solar cell protective sheets obtained in the examples and the comparative example into 300 mm×300 mm square to be placed on a horizontal table, and vertical distances (mm) were measured from the table surface to four corners. Obtained distances at four points were used to calculate an average value representing the curl amount (mm). Results are shown in Table 1.

**[Table 1]**

| | Pigment | Compounding amount of pigment | Curl amount |
|---|---|---|---|
| | | (mass%) | (mm) |
| Example 1 | Titanium oxide | 2.5 | 25 |
| Example 2 | Titanium oxide | 15.0 | 14 |
| Example 3 | Titanium oxide | 35.0 | 10 |
| Example 4 | Magnesium oxide | 15.0 | 18 |
| Example 5 | Cerium oxide | 15.0 | 13 |
| Example 6 | Talc | 15.0 | 16 |
| Example 7 | Calcium carbonate | 15.0 | 16 |
| Example 8 | Carbon black | 3.0 | 22 |
| Example 9 | Titanium oxide | 15.0 | 5 |
| Example 10 | Carbon black | 3.0 | 8 |
| Comparative Example 1 | - | - | 32 |

As understood from Table 1, the solar cell protective sheets of the examples had small curl amounts.

### [Industrial Applicability]

The solar cell protective sheet according to the present invention may preferably be utilized as a back sheet of a solar cell module, for example.

### [Explanation of Numeral References]

1, 1A, 1B... Solar cell protective sheet
11... Substrate
12A... Thermoplastic resin layer (single layer)
12B... Thermoplastic resin layer (two layers)
   121... First layer
   122... Second layer
12C... Second thermoplastic resin layer
13... Fluorine resin layer
   14... Vapor-deposited layer
   15... Adhesive layer
   16... Metal sheet
2... Solar cell
3... Encapsulant
4... Glass plate
10... Solar cell module

## Claims

1. A solar cell protective sheet comprising a substrate and a thermoplastic resin layer laminated on at least one surface of the substrate, wherein
the thermoplastic resin layer comprises at least one pigment selected from the group consisting of titanium oxide, talc, magnesium oxide, cerium oxide, barium sulfate, calcium carbonate and carbon black.

2. The solar cell protective sheet as set forth in claim 1, wherein the thermoplastic resin layer is a single layer and comprises an olefin-based resin as a main component, and the olefin-based resin has a density of 875 to 920 kg/m³ and a heat of fusion ΔH measured with a differential scanning calorimeter of 100 J/g or less.

3. The solar cell protective sheet as set forth in claim 2, wherein the thermoplastic resin layer contains 2.5 to 35 mass% of the pigment.

4. The solar cell protective sheet as set forth in claim 1, wherein
the thermoplastic resin layer comprises: a first layer laminated on the substrate and exhibiting adhesiveness to the substrate; and a second layer laminated on the first layer and containing an olefin-based resin as a main component, and
the olefin-based resin of the second layer has a density of 875 to 920 kg/m³ and a heat of fusion ΔH measured with a differential scanning calorimeter of 100 J/g or less.

5. The solar cell protective sheet as set forth in claim 4, wherein the pigment is contained in the second layer.

6. The solar cell protective sheet as set forth in claim 5, wherein 2.5 to 35 mass% of the pigment is contained in the second layer.

7. The solar cell protective sheet as set forth in either one of claims 2 to 6, wherein the olefin-based resin contains 60 to 100 mass% of ethylene as a monomer unit.

8. The solar cell protective sheet as set forth in either one of claims 4 to 6, wherein the first layer mainly comprises a copolymer of ethylene and at least one selected from the group consisting of (meth)acrylic acid, (meth)acrylic acid ester and vinyl acetate.

9. The solar cell protective sheet as set forth in claim 8, wherein a total content of (meth)acrylic acid, (meth)acrylic acid ester and vinyl acetate as a monomer unit in the copolymer of the first layer is 2 to 40 mass%.

10. The solar cell protective sheet as set forth in claim 8 or 9, wherein (meth)acrylic acid ester as a monomer unit in the copolymer of the first layer is at least one selected from the group consisting of methyl acrylate, butyl acrylate, 2-ethylhexyl acrylate and methyl methacrylate.

11. The solar cell protective sheet as set forth in either one of claims 1 to 10, wherein the thermoplastic resin layer is formed by extrusion coating.

12. The solar cell protective sheet as set forth in either one of claims 1 to 11, wherein the thermoplastic resin layer is a layer to be adhered to an encapsulant that constitutes a solar cell module.

13. A producing method of a solar cell protective sheet comprising a substrate and a thermoplastic resin layer laminated on at least one surface of the substrate comprising:
extrusion coating the thermoplastic resin composition, which comprises an olefin-based resin as a main component, the olefin-based resin having a density of 875 to 920 kg/m³ and a heat of fusion ΔH measured with a differential scanning calorimeter of 100 J/g or less, and at least one pigment selected from the group consisting of titanium oxide, talc, magnesium oxide, cerium oxide, barium sulfate, calcium carbonate and carbon black, onto at least one surface of the substrate, then
forming the thermoplastic resin layer.

14. A producing method of a solar cell protective sheet comprising a substrate and a thermoplastic resin layer laminated on at least one surface of the substrate comprising:
co-extrusion coating a first resin composition and a second resin composition onto at least one surface of the substrate so that the first resin composition is located at a side of the substrate, the first resin composition has an adhesiveness to the substrate and the second resin composition comprises an olefin-based resin as a main component and at least one pigment selected from the group consisting of titanium oxide, talc, magnesium oxide, cerium oxide, barium sulfate, calcium carbonate and carbon black, the olefin-based resin having a density of 875 to 920 kg/m³ and a heat of fusion ΔH measured with a differential scanning calorimeter of 100 J/g or less, then
forming the thermoplastic resin layer which comprises the first layer laminated on the substrate comprising the first resin composition and the second layer laminated on the first layer comprising the second resin composition.

15. A solar cell module comprising a solar cell, an encapsulant that encapsulates the solar cell, and a solar cell protective sheet laminated on the encapsulant, wherein
the solar cell protective sheet comprises the solar cell protective sheet as set forth in claim 12, and
the solar cell protective sheet is adhered to the encapsulant via the thermoplastic resin layer.
